# EUROPEAN PATENT APPLICATION

(11) **EP 4 783 750 A1**
(43) Date of publication of application: **29.07.2026**
(21) Application number: 25154245.2
(22) Date of filing: 27.01.2025
(51) Int. Cl.: H05K 1/02, H05K 3/46, H05K 1/03

(54) **COMPONENT CARRIER WITH VERTICALLY CONNECTED CAVITY SUB-PORTIONS**

(71) Applicant: AT&S Austria Technologie & Systemtechnik Aktiengesellschaft, 8700 Leoben (AT)
(72) Inventor: Takahashi, Hiroaki, 1090 Vienna (AT); Schlaffer, Erich, 8642 St. Lorenzen (AT); Schlick, Daniel, 8733 St. Marein-Feistritz (AT); Trischler, Heinrich, 8063 Eggersdorf bei Graz (AT); Kaltalioglu, Batuhan, 8700 Leoben (AT); Ebner, Claudia, 8583 Edelschrott (AT); Vockenberger, Christian, 8700 Leoben (AT); Alothman Alterkawi, Ahmad Bader, 8020 Graz (AT)
(74) Representative: Dilg, Haeusler, Schindelmann Patentanwaltsgesellschaft mbH

(57) **Abstract**

There is described a component carrier (100) having a stack (101), wherein the stack (101) comprises:
i) at least one electrically conductive layer structure (104) and at least one electrically insulating layer structure (102); and
ii) a cavity (105) provided in the stack (101),
wherein the cavity (105) comprises:
a) a first cavity portion (110) provided on a first vertical level (hl) of the stack (101), wherein the first cavity portion (110) partially vertically extends along the thickness of a first electrically insulating layer structure (112) of the at least one electrically insulating layer structure (102), and
b) a second cavity portion (120) provided on a second vertical level (h2) of the stack (101), wherein the first cavity portion (110) and the second cavity portion (120) are connected to each other through their vertical thickness extension (z) in the stack (101).

## Description

### Field of the Invention

The invention relates to a component carrier having a stack, comprising at least one electrically conductive layer structure and at least one electrically insulating layer structure, and a cavity provided in the stack, wherein the cavity comprises: a first cavity portion provided on a first vertical level of the stack, wherein the first cavity portion partially vertically extends along the thickness of a first electrically insulating layer structure of the at least one electrically insulating layer structure, and a second cavity portion provided on a second vertical level of the stack, wherein the first cavity portion and the second cavity portion are connected to each other through their vertical thickness extension in the stack. Further, the invention relates to a method of manufacturing such a component carrier.

Accordingly, the invention may relate to the technical field of component carriers, such as printed circuit boards or IC substrates, and their manufacture.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically and magnetically reliable so as to be operable even under harsh conditions.

Radio frequency (RF) applications have become more and more important in the field of component carriers. For example, antennas (e.g. patch, slot, or wave guide antennas) can be implemented in or coupled to component carriers. Further, an RF/antenna board may be part of a radar application. Yet, these important (antenna) implementations may still be seen as a challenge with respect to signal transmission performance and space requirements, in particular regarding wave guides.

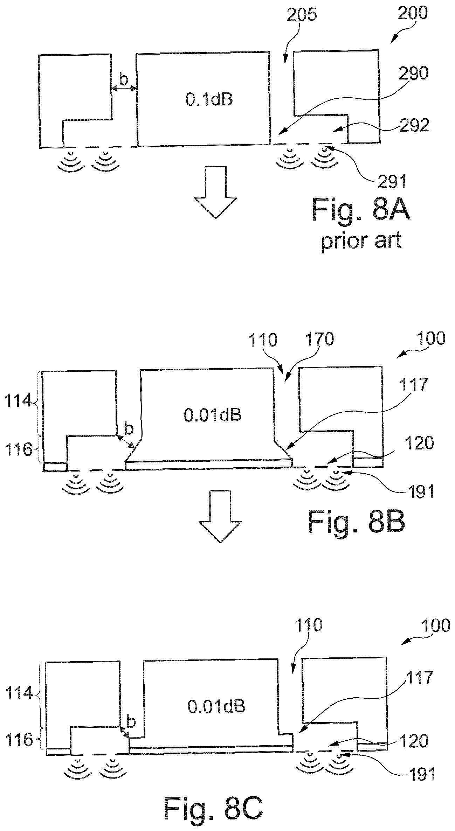

**Figure 8A** shows a conventional antenna device 200 with a wave guide 205. A first part of the wave guide 205 is formed in the z-direction, while a second part of the wave guide 205 is formed in the planar (x-y) direction 292. At the transition between the first part and the second part, there is the so-called bending transition 290, wherein the signal is bent by 90°. The antenna device 200 comprises openings at the bottom of the second part 292, wherein said openings serve as slot antennas 291. As indicated in this Figure, the insertion loss of the signal, due to the bending transition, is around 0.1 dB.

### Summary of the Invention

There may be a need to provide an efficient and reliable component carrier. According to an exemplary embodiment of the invention, a component carrier and a method are described.

According to an aspect of the invention, there is described a component carrier comprising a (multi-layer) stack, wherein the stack comprises:
i) at least one electrically conductive layer structure and at least one electrically insulating layer structure, and
ii) a cavity provided in the stack, wherein the cavity comprises:
   iia) a first cavity portion (in particular with a first sub-portion and a second sub-portion) provided on a first vertical level of the stack (e.g. formed from a first main surface of the stack), wherein the first cavity portion (only) partially vertically extends along the thickness of a first electrically insulating layer structure of the at least one electrically insulating layer structure, and
   iib) a second cavity portion provided on a second vertical level of the stack (e.g. formed from a second main surface of the stack, being opposed to the first main surface), wherein the first cavity portion and the second cavity portion are connected to each other through their vertical thickness extension in the stack (in particular offset with respect to each other).

According to an aspect of the invention, there is described a method of manufacturing a component carrier, the method comprising:
i) providing a stack having at least one electrically conductive layer structure and at least one electrically insulating layer structure;
ii) providing a cavity in the stack, so that the cavity comprises:
   iia) a first cavity portion provided on a first vertical level of the stack, wherein the first cavity portion partially vertically extends along the thickness of a first electrically insulating layer structure of the at least one electrically insulating layer structure, and
   iib) a second cavity portion provided on a second vertical level of the stack, wherein the first cavity portion and the second cavity portion are connected one to each other through their vertical thickness extension in the stack.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board (PCB), an organic interposer, and an integrated circuit (IC) substrate. A component carrier may also be a hybrid board combining different ones of the above-mentioned types of component carriers.

In the context of the present document, the term "stack" may particularly denote a flat or planar sheet-like body. For instance, the stack may be a layer stack, in particular a laminated or rolled layer stack. Such a laminate may be formed by connecting a plurality of layer structures by the application of mechanical pressure and/or heat. Preferably, the plurality of layer structures are aligned parallel on top of each other. The stack may comprise electrically conductive structures and at least one electrically insulating structure.

In the context of the present document, the term "layer structure" may particularly denote a continuous layer, a patterned layer or a plurality of nonconsecutive islands (discontinuous) within a common plane, and it may perform the function of electrical conductivity and/or electrical insulation. A layer structure may also comprise an interconnection structure which protrudes from a planar surface of the layer structure.

In the context of the present document, the term "first cavity portion" may particularly denote a cavity formed in a component carrier stack, wherein said cavity is one of at least two connected cavities. For example, a first cavity portion may be provided by forming a cavity from a first main surface of the stack (e.g. by drilling). Such a first cavity portion may extend vertically and/or parallel along the thickness of one or more electrically insulating layer structures. Hereby, in an embodiment, the first cavity portion vertically extends, with respect to one particular (first) electrically insulating layer structure, only partially along the thickness. The partially vertically extending part (e.g. straight lateral wall) may be defined as a first sub-portion of the first cavity portion, while the not vertically extending part (e.g. inclined, partially horizontally extending, multi-stepped) may be defined as a second sub-portion of the first cavity portion. In an embodiment, the first cavity portion (and sub-portions thereof) can extend through one or more layers.

In the context of the present document, the term "second cavity portion" may particularly denote a further cavity formed in a component carrier stack, wherein said cavity is another one of at least two connected cavities. For example, a second cavity portion may be provided by forming a further cavity from a second main surface of the stack (e.g. by drilling), being in particular opposed to the first main surface. In an embodiment, a second cavity portion may have an equal or larger (or smaller) size than a first cavity portion. In a further embodiment, a second cavity portion may be formed in the first place and subsequently, the first cavity portion is formed. Alternatively, the first cavity portion may be formed in the first place and subsequently, the second cavity portion is formed. In an embodiment, the second cavity portion extends in the vertical direction and/or parallel to the thickness direction along at least one (in particular two or more) electrically insulating layer structure(s). In a further embodiment, the lateral walls of the second cavity portion are (essentially) straight. In an embodiment, the second cavity portion (and sub-portions thereof) can extend through one or more layers.

In the context of the present document, the term "connected through their vertical thickness extension" may particularly refer to the circumstance that a first cavity portion and a second cavity portion are arranged at different vertical heights of a component carrier stack and are connected (e.g. so that a signal can travel through the first cavity portion and the second cavity portion), for example one above the other. When seen in the planar view, the cavity portions may be offset (in the horizontal directions), yet there may be an overlapping region, where the cavity portion may be connected. In an example, at least a portion (of an extremity) of the first cavity portion and at least a portion (of an extremity) of the second portion may share a common volume.

According to an exemplary embodiment, the invention may be based on the idea that an efficient and reliable component carrier can be provided, when a layer stack is provided with two cavity portions at different vertical heights, wherein said two cavity portions are interconnected in the vertical direction, so as to form a common cavity, for example to provide a wave guide for RF applications. Forming such a cavity by two (or more) cavity portions may provide the advantage of very flexible and application-oriented manufacture options, e.g. forming the cavity portions from opposed main surfaces. Such an architecture may reflect an intermediated process step during the manufacture process.

The cavity portions extend vertically along the thickness of the stack electrically insulating layer structures. In an embodiment, the first cavity portion (in a region connected with the second cavity portion) extends partially along the thickness of an electrically insulating layer structure. Such a partial vertical extension may be realized by a suitable manufacture process, e.g. routing and/or drilling, to form an additional structure in the cavity (in particular wave guide), such as a multi-step portion, an inclination, an intermediate cavity surface, etc.

It has been found by the inventors that such an additional structure in the cavity may be formed in an efficient and flexible manner in a process of forming and interconnecting two cavities located at different vertical heights. For example, such an approach may be used to decrease a signal loss in a wave guide, in particular regarding high frequencies. With this approach, a 3D wave guide application may be provided in an efficient manner.

At least one of the following advantages may be enabled by this architecture: signal routing through wave guide in three dimensions, reduced insertion loss, perform impedance matching, eliminating use of low-Dk materials, miniaturizing 3D wave guide structures, connecting an RF-IC (radio frequency integrated circuit, e.g. transmitter, receiver, transceiver, power amplifier) with a LiP (launcher in package) configuration (meaning that a signal coupling structure is obtained directly on a package of the RF-IC (over-mold); the coupling structure can emit the RF signal directly into the cavity (transmission through air)). The described component carrier may be applied for example for antenna or radar applications, e.g. RF antenna front end modules, base stations and radio access networks (RAN).

In an exemplary embodiment of the invention, interfaces with the opening can be reduced, allowing to improve the signal performance. By such an opening, large connection structures (such as solder balls) can be eliminated and the RF signal can be directly emitted into the cavity (compared to conventional component carrier architecture).

### Exemplary Embodiments

In an embodiment, the first cavity portion comprises a first sub-portion with a first external wall (in particular a lateral wall). In an embodiment, the first cavity portion comprises a second sub-portion with a second external wall (in particular a non-lateral wall). In an embodiment, the first sub-portion and the second sub-portion are, in particular vertically, stacked. In an embodiment, the first external wall extends differently from the second external wall, in particular along the vertical direction (z). This may provide the advantage that a structural feature within the cavity may be provided in an efficient and straightforward manner, in particular (only) within the thickness of one or more (a plurality of) electrically insulating layer structure(s). For example, the first sub-portion and the second sub-portion may be arranged in direct contact with each other, for example via an interface region.

In an embodiment, the first external wall comprises a vertical extension and/or a straight extension. Thus, the first sub-portion may be formed with lateral walls which are (essentially) straight and/or have a vertical extension (along z). This may shorten the overall length of the cavity to the adjacent exposed surface and thus may accelerate the signal transmission. In an embodiment, the second external wall comprises an inclined extension and/or a not straight extension and/or a not vertical extension and/or a non-lateral external wall. Hereby, the second sub-portion may form the structural feature in the cavity, that may for example advantageously influence a signal transport through a wave guide.

In an embodiment, the inclination (angle) of the first external wall is different from the inclination (angle) of the second external wall. In an embodiment, the first external wall and the second external wall may be oriented in a different angle, for example the first external wall may be arranged 0° with respect to the z-axis, while the second external wall may be arranged in an angle of 90° or more with respect to the z-axis (e.g. a horizontally oriented inclination).

In an embodiment, the second external wall comprises an irregular extension. Such a configuration may be provided on purpose to enhance specific desirable effects, for example additional reduction of insertion loss of an RF and/or HF signal. For example, the external wall may comprise a multi-step portion. In another example, the external wall may have a rough surface and/or a curved surface, e.g. concave or convex (regions).

In an embodiment, the second external wall comprises an at least partially rounded extension. Such a structural feature may in particular be the result of a manufacturing process. For example, a manufacture using a routing process (in particular a routing bit) may form such a rounded extension. This may further enhance the signal propagation quality, since the less (sharp) edges the better the signal propagation quality may be.

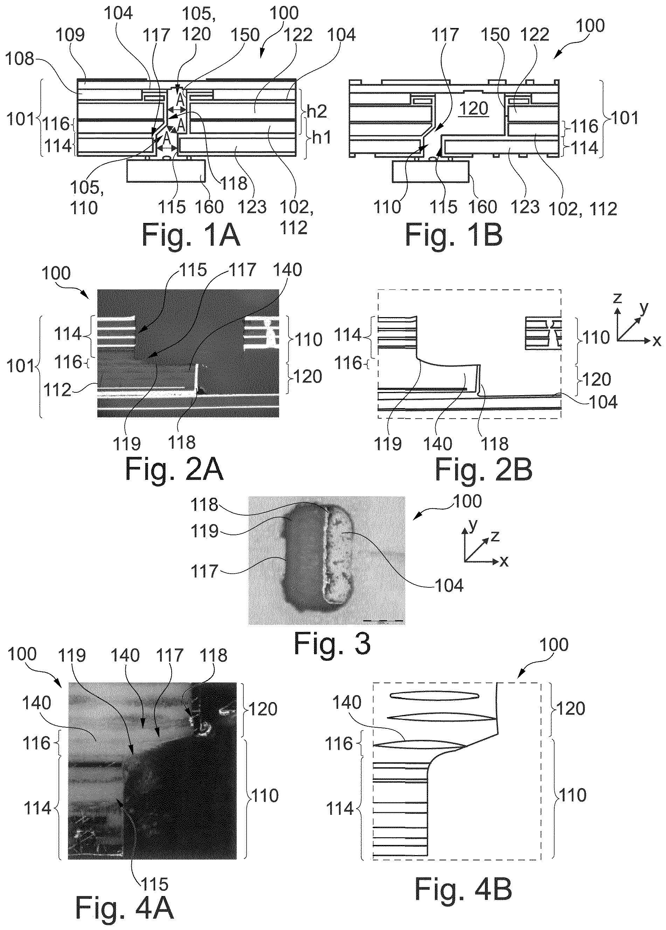

In an embodiment, the first sub-portion is delimited (laterally) by one or more, in particular two or more electrically insulating layer structures. Depending on the present application, the first sub-portion may extend through one (and a part in case of Figure 1A) electrically insulating structures or through a plurality of electrically insulating layer structures (compare e.g. the layers of Figure 2A). Thus, the first sub-portion may be provided in a design-flexible manner in thinner or thicker stacks. The thickness of the first sub-portion in thickness direction may have an impact on the quality of RF signal and/or HF signal transmission and/or on the speed of RF signal and/or HF signal transmission. The inventors found out, that losses generated by two or more electrically insulating layer structures, in particular the thickness of two or more electrically insulating layer structures may have a negligible impact on the contribution on signal losses.

In an embodiment, the second sub-portion is delimited (laterally) by one, in particular exclusively one, electrically insulating layer structure. Alternatively, the second sub-portion is delimited (laterally) by two or more (a plurality of) layer structures comprising e.g. at least one electrically conductive layer structure and at least one electrically insulating layer structure. This may provide the advantage that the non-lateral wall (and the structural feature in the cavity) may be formed in a minimal (regarding space requirement) region, thereby improving miniaturization of the component carrier. Further, the signal performance may be improved by minimizing the losses when the E-field is bended by 90°. Instead of a plurality of layer structures, the second sub-portion (and the second external wall) can be realized (partially) in only one layer structure.

In an embodiment, the first cavity portion and the second cavity portion (in particular the second external wall of the second sub-portion and the lateral wall of the second cavity portion), define an exposed profile within the cavity. In this context, the term "exposed profile" may in particular refer to a profile (e.g. a shape, a wall, a structure; following a specific extension) that is exposed (e.g. to fluid such as air) in the cavity. Specifically, an exposed profile may be formed by a lateral/external wall that delimits (partially) the second cavity portion and starts the extension at a region that is associated with the second sub-portion. For example, the exposed profile may be arranged at an interface of the first cavity portion (in particular the second sub-portion) and the second cavity portion. In an embodiment, the exposed profile may comprise a metallized lateral/external wall (see for example Figure 3). The exposed profile may be created such, that it does not contribute to signal losses and mechanically and/or chemically protects at least a portion of the first cavity portion and at least a portion of the second cavity portion from environmental influences, for example due to the physical and/or chemical material properties of the exposed profile.

In an embodiment, the second sub-portion comprises a stepped, in particular multi-step, portion. In an embodiment, the exposed profile comprises a stepped, in particular multi-step, portion. This may provide the advantage that a signal loss in the cavity (e.g. as a wave guide) may be reduced (compare Figure 8C). When forming the vertical connection of the first cavity portion and the second cavity portion, a portion with a step (or two or more steps) can be formed at the interface. In an example, this stepped portion can be part (e.g. the external wall) of the second sub-portion (of the first cavity). In a further example, the stepped portion can include the second sub-portion (of the first cavity) and part (e.g. the lateral wall) of the second cavity.

In an embodiment, the exposed profile defines at least one rounded profile, when seen from a planar view (z) (compare e.g. Figure 3). Such a rounded profile may reflect a specific manufacture process, e.g. routing. In an embodiment, the exposed profile (and/or an intermediate cavity surface) comprises rounded traces that reflect a (drilling bit of a) routing manufacture process. The rounded profile may reduce the signal losses due to its geometrical shape, especially when the signal has to be translated from horizontal direction to vertical direction and vice versa.

In an embodiment, the first cavity portion (in particular the second external wall of the second sub-portion), delimits an intermediate cavity surface (in particular being at least partially planar) on the first electrically insulating layer structure. This may simplify the manufacturing process, since the material removal of electrically insulating layer structure material may be easier compared with the removal of electrically conductive layer structure material due to the physical properties, for example the hardness. Additionally or alternatively, the manufacturing process may be accelerated due to the aforementioned physical property's difference.

In the present context, the term "intermediate cavity surface" may in particular refer to a region/area of the second sub-portion (in particular the second external wall). In an embodiment, the intermediate cavity surface is oriented (essentially) in a planar/horizontal manner. For example, the intermediate cavity surface may be a part of the second external wall that is slanted or inclined, rather horizontally than vertically. In an embodiment, the intermediate cavity surface may refer to a horizontal extension of the second external wall, while the exposed profile may refer to a vertical extension of the second external wall. For this reason, the intermediate cavity surface may be (well) visible from a planar view (compare e.g. Figure 3).

In an embodiment, the intermediate cavity surface comprises a rough surface. In an example, the rough surface may have a roughness Ra larger than 5 µm, in particular 10 µm. Additionally or alternatively, the rough surface may have a roughness Ra in the range from 250 nm to 5 µm. In an embodiment, the intermediate cavity surface comprises a roughness that defines patterned circular sketches, in particular reflecting a routing manufacture process. For example, traces of a routing/drilling bit of the manufacture process may be visible on the intermediate cavity surface (in particular from a planar view). The rough surface may simplify the process to add an electrically conductive material on the surface, since a preceding roughening process step which is required for preferred electrically conductive material application process step can be skipped.

In an embodiment, the first electrically insulating layer structure comprises a reinforcing structure (e.g. fibers, spheres, a fiber-free reinforcement) embedded therein. In an embodiment, the first cavity portion (in particular the second external wall of the second sub-portion), delimits the intermediate cavity surface on the first electrically insulating layer structure. In an embodiment, the reinforcing structure is partially exposed at the intermediate cavity surface. Preferably, the reinforcing structures may be at least partially, in particular fully, covered by a metal layer. This structural feature may reflect the process of forming the first cavity portion in the stack. For example, the first cavity portion may be formed by drilling (e.g. routing, mechanical/laser drilling) from one main surface of the stack to the center of the stack. This formation process removes material of the first electrically insulating layer and may thereby expose reinforcing structures embedded in the first electrically insulating layer (e.g. fibers in a resin matrix). Without the specific formation process of the first cavity portion, said reinforcing structures may not be exposed and still encapsulated in resin material.

In an embodiment, different portions of the second sub-portion expose a different amount and/or a different portion of the reinforcing structure. Preferably, the reinforcing structures may be at least partially, in particular fully, covered by a metal layer. This may provide the advantage that the second sub-portion comprises a specific (irregular) shape, e.g. a stepped portion, an inclination, a slope, etc. Thereby, specific advantageous signal transmission properties may be adjusted.

In an embodiment, the reinforcing structure is exposed lengthwise with respect to the second sub-portion extension towards the second cavity portion. Reinforcing structures such as fibers may be oriented in the first electrically insulating layer structure along the planar (horizontal) direction. Thus, a lengthwise exposure may be achieved by forming the cavity in the vertical direction.

In an embodiment, the intermediate cavity surface has a roughness higher than the roughness of the lateral wall of the first cavity portion, in particular of the first external wall of the first sub-portion. Such a roughness may be a relic from the manufacture process. This may provide the advantage of specific effects for signal transmission, in particular since the intermediate cavity surface may act as (part of) the bending portion between the first cavity portion and the second cavity portion. Additionally, the intermediate cavity may comprise a metalized layer. The metalized layer may follow the structure of the reinforcing structure and thus may have a different roughness (higher) than the lateral wall.

In an embodiment, the lateral wall of the first cavity portion defines a rounded profile in a planar view, in particular a polyhedral profile with rounded edges (see e.g. Figure 3). Such a rounded profile/portion may reflect a manufacture process, e.g. routing. Alternatively, the lateral wall of the first cavity portion defines an angular profile in a planar view. Thus a rounded profile can be manufactured with low effort in a fast an easy way. In a further embodiment, the lateral wall of the first cavity portion defines a stepped (e.g. one or more steps) profile.

In an embodiment, the cavity is at least partially, in particular fully, metallized, in particular by a metalized layer (e.g. by plating). This may provide the advantage of improved signal transmission. In an embodiment, the reinforcing structure are at least partially, in particular fully, covered by the metalized layer.

For example, the cavity may be configured as a wave guide and (at least partially) metallized sidewalls are known to increase signal transmission performance. Further, the stability can be improved, and the cavity walls may be protected.

In an embodiment, a metalized portion of the metalized layer comprises multiple stacked metalized layers. In an embodiment, the metalized portion corresponds to the lateral wall of the first cavity portion and/or the lateral wall of the second cavity portion. In an embodiment, the above described exposed profile may be metallized. In a further embodiment, the intermediate cavity surface may be metallized. This may provide improved signal transmission performance, in particular at the signal bending region. In an embodiment, thicker metallization, for example larger than 20 µm, in particular larger than 35 µm, is used if the surface roughness obtained through the routing/drilling process is too high. A plating process can level the surface roughness, in an example.

In an embodiment, a first metalized portion of the metalized layer that corresponds to the lateral wall of the first cavity portion is thinner or thicker (or equal) than a second metalized portion of the metalized layer that corresponds to the lateral wall of the second cavity portion. Depending on the desired application, sidewalls of the first cavity portion and the second cavity portion may be metallized in a different manner.

In an embodiment, the first cavity portion is offset with respect to the second cavity portion in the vertical direction (when seen in a planar view, perpendicular to the directions of main extension of the component carrier). In an embodiment, the first cavity portion and the second cavity portion partially overlap along the stack thickness direction (z). This may bring the advantage, especially when the first cavity portion and the second cavity portion are connected, that low losses are generated by the material located in between the first cavity portion and the second cavity portion.

In an example, the material in the first cavity portion and/or in the second cavity portion and/or between the first cavity portion and the second cavity portion may comprise or consist of air having a relative permittivity at room temperature in the range from 1.0004 to 1.0007. In an embodiment, the first cavity portion and the second cavity portion are connected in the overlapping portion. In other words, the first cavity portion and the second cavity portion are arranged at different vertical heights and at different horizontal positions in the stack. Yet, in an embodiment, there is at least one overlap portion (when seen in the thickness direction of the stack), wherein said overlap portion can be used as the vertical connection. In an embodiment, the offset may enable a 3D wave guide structure for different purposes. Thereby, the vertical connection may be realized in an efficient and reliable manner.

In an embodiment, the first cavity portion and the second cavity portion have a different shape/dimension, in particular different edges. This may provide the advantage that the cavity may be designed in a flexible and practical manner. Depending on different sizes/shapes/characteristics of the cavity portion, a plurality of interesting cavity properties may be obtained/adjusted; for example adjusting the dimension of the second cavity portion may reduce the transmission loss for a respective frequency.

In an embodiment, the second sub-portion is located at/in an inner layer structure. In an embodiment, the second sub-portion is not located at/in an exterior (electrically insulating) layer structure (compare e.g. Figure 1A). This may provide the advantage that the bend portion is embedded/buried in the stack.

In an embodiment, the cavity comprises a third cavity portion connected to the first cavity portion. In an embodiment, the third cavity portion is arranged opposed to the second cavity portion. In an embodiment, the first cavity portion, the second cavity portion, and the third cavity portion are connected one to each other through their, in particular vertical, extension in the stack. The cavity may comprise more than two portions, e.g. a third cavity portions. In an embodiment, the two or more cavity portions are connected to form the cavity (wave guide structure). Thereby, a large variety of advantageous designs may be enabled. The third cavity portion may be designed like the first cavity portion (with a second sub-portion (external wall)) or like the second cavity portion.

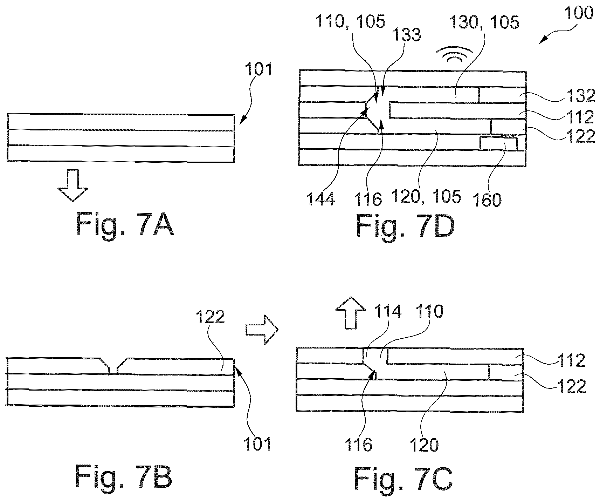

In an embodiment, the cavity has a U-shaped cross section. In an embodiment, the two extremities (of the U-shaped cross-section) are defined by the second cavity portion and the third cavity portion. In an embodiment, said extremities are connected by the first cavity portion. Hereby, the first cavity portion may comprise one or more (two or more) second sub-portions with corresponding second external walls (compare e.g. Figure 7D). In this manner, the advantages of a stepped/inclined external wall may be implemented at a plurality of positions within the wave guide. In an embodiment, the cavity comprises two or more second sub-portions (e.g. a third sub-portion) with corresponding second external walls.

In an embodiment, the first cavity portion partially vertically extends in the thickness of two (or more) electrically insulating layer structures composing the stack. In an embodiment, each one of said two (or more) electrically insulating layer structures is connected to either the second cavity portion or the third cavity portion. This may provide the advantage of an interface for the cavities, which may be arranged along the planar/horizontal direction of a respective electrically insulating layer structure.

In an embodiment, the first cavity portion comprises a third sub-portion arranged opposite to the second sub-portion and stacked with the first sub-portion. In an embodiment, the third sub-portion comprises an external wall extending differently than the first external wall of the first sub-portion. For example, the external walls may be oriented in different/opposed directions/angles. Thereby, a U-shape may be realized in a straightforward manner.

In an embodiment, the cavity is at least partially configured as a wave guide. In an embodiment, the cavity is configured for at least one of the following applications: RF, HF, radar, mm-wave, 60 GHz or higher applications; RF applications operating at mmWave and higher frequencies, for example radar, 5G, 6G, etc. Thereby, technically/economically important applications may be realized in an efficient and reliable manner.

In an exemplary embodiment, it is proposed a method on how a bent fluid/air-filled embedded wave guide can be realized on PCB level. Moreover, the possibility is considered of optimizing the performance by embedded an RFIC. A straight wave guide may not satisfy specific design requirements such as transition from one layer to another layer, or due to signal path there should a bend of the waveguide in x-y axis. The present disclosure may enable a low loss bent air-filled wave guide structure in a component carrier.

In an exemplary embodiment, there is described a RF channel comprising 90° bend-structures that have been shown to improve the RF performance. Slanted sidewalls may allow for manufacturing wave guides having a constant channel-diameter throughout the whole feeding network. Keeping the diameter constant may significantly decrease the insertion loss, e.g. from 0.1 dB to smaller than 0.05 dB, in particular in the range from 0.005 to 0.04.

In an exemplary embodiment, providing the cavity comprises drilling, in particular at least one of mechanical drilling, in particular routing, laser drilling. In an exemplary embodiment, providing the cavity comprises etching, e.g. wet etching and/or plasma/ion etching. This may provide the advantage that established and reliable PCB techniques may be directly applied to precisely form the cavity.

In an exemplary embodiment, the method further comprises forming the first cavity portion in one or more electrically insulating layer structures (in particular in the first electrically insulating layer structure), in particular by drilling. In an exemplary embodiment, the method further comprises forming the second cavity portion in one or more electrically insulating layer structures, in particular by drilling. In an embodiment, the first cavity portion and the second cavity portion are manufactured with similar or different processes. In an embodiment, the first cavity portion and the second cavity portion are formed at the same time or subsequently. In an embodiment, the first cavity portion and the second cavity portion are formed in a common manufacture step. Thereby, time and efforts may be saved.

In an exemplary embodiment, the second cavity portion is formed in a first portion of the stack. In an exemplary embodiment, the first cavity portion is formed afterwards by drilling in a second portion of the stack. The term "stack portions" may in this context refer to different sections of the stack. These portions may be separated or may overlap. In an embodiment, the first portion may be separate from the second portion, when at least one of the cavity portions is formed. For example, the second cavity portion may be formed (partially) in a first portion that is then assembled to the second portion of the stack. Thereby, a flexible and efficient manufacture process may be enabled.

In an exemplary embodiment, the first cavity portion is formed from a first direction (+z). In an exemplary embodiment, the second cavity portion is formed from a second direction (-z). In an exemplary embodiment, the first direction (+z) is opposed to the second direction (-z). Such a manufacture process may enable the vertical connection of two cavity portions in a highly efficient and flexible manner. By using this approach, a specific structural feature in a wave guide (such as a step or an inclination) may be generated in an accurate manner, in particular when forming the first cavity portion to be connected to the second cavity portion.

In an embodiment, the first cavity portion and/or the second cavity portion is associated with an antenna structure and/or a component. Thereby, the flexibility (of applications) may be increased. Additionally or alternatively, a short and/or fast transmission of (RF) signals may be ensured between the first cavity portion and the antenna structure or the component and/or between the second cavity portion and the antenna structure or the component.

In an exemplary embodiment, the method further comprises metalizing at least part of the lateral walls of the cavity, in particular using plating. This may provide the advantage that signal transmission performance may be increased using established and reliable processes.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board.

A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, titanium, molybdenum and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be surface mounted on and/or embedded in the component carrier. Said component may be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.

### Brief Description of the Drawings

The aspects defined above and further aspects of the invention are apparent from the examples of embodiment to be described hereinafter and are explained with reference to these examples of embodiment.
Figure 1A shows a component carrier, according to an exemplary embodiment of the invention.
Figure 1B shows a further component carrier, according to an exemplary embodiment of the invention.
Figure 2A shows a microscopic image of a cross-section through a component carrier and Figure 2B shows a schematic illustration of said component carrier, according to an exemplary embodiment of the invention.
Figure 3 shows a top view on a portion of a component carrier, according to an exemplary embodiment of the invention.
Figure 4A shows a microscopic image of a cross-section through a component carrier and Figure 4B shows a schematic illustration of said component carrier, according to an exemplary embodiment of the invention.
Figures 5A, 5B, 5C, and 5D show a process of manufacturing a component carrier, according to an exemplary embodiment of the invention.
Figure 6A shows an illustration of a waveguide in a component carrier, while Figure 6B shows simulation results for said wave guide, according to an exemplary embodiment of the invention.
Figure 7a, Figure 7B, Figure 7C, and Figure 7D show manufacturing a further component carrier, according to an exemplary embodiment of the invention.
Figure 8A shows a conventional antenna device, while Figure 8B and Figure 8C show respectively a component carrier, according to exemplary embodiments of the invention.

### Detailed Description of the Drawings

**Figure 1A** shows a component carrier 100, according to an exemplary embodiment of the invention, having a stack 101, wherein the stack 101 comprises a plurality of electrically conductive layer structures 104 and a plurality of electrically insulating layer structures 102. In this example, the stack 101 comprises (from bottom to top): a fourth electrically insulating layer structure 123 (configured as a core layer), a first electrically insulating layer structure 112 (configured as a prepreg layer), a second electrically insulating layer structure 122 (configured as a core layer), a further electrically insulating layer structure 108 (configured as a prepreg layer), and a further core layer 109. The stack 101 further comprises a cavity 105 consisting of a first cavity portion 110 and a second cavity portion 120.

The first cavity portion 110 is provided on a first vertical level h1 of the stack 101, wherein the first cavity portion 110 extends vertically (along a rather straight vertical line) along the thickness of a fourth electrically insulating layer structure 123 (here a core layer) and partially vertically extends along the thickness of a first electrically insulating layer structure 112 of the plurality of electrically insulating layer structures 102. It can be seen that the vertical extension of the first cavity portion 110 along the first electrically insulating layer structure 112 is only partial, since the extension is not vertical through the whole thickness of said layer 112, but the extension changes direction to the horizontal (inclination). In an embodiment, the inclination is implemented to keep the diameter of the waveguide constant. Otherwise, signal losses, especially E-bend losses, may occur (as H-bend diameter stay constant anyway).

The second cavity portion 120 is provided on a second vertical level h2 (different from the first vertical level h1) of the stack 101. The first cavity portion 110 and the second cavity portion 120 are connected to each other through their vertical thickness extension (along z) in the stack 101. Hereby, when seen in a planar view (along z), the first cavity portion 110 and the second cavity portion 120 are offset with respect to each other. Even though there is an offset in the horizontal direction, both cavity portions 110, 120 overlap and are connected to form a common cavity 105. For this reason, the two vertical height h1 and h2 overlap at the connection between the cavity portions 110, 120. The first cavity portion 110 and the second cavity portion 120 have a different shapes/dimensions.

The first cavity portion 110 comprises a first sub-portion 114 with a first external wall 115 (the lateral wall). In this example, the first external wall 115 is a straight sidewall that extends along fourth electrically insulating layer structure 123 and along a part (i.e. partially) of the first electrically insulating layer structure 112. As described above, along the thickness direction of the first electrically insulating layer structure 112, the vertical extension changes to a second external wall 117 of a second sub-portion 116. The first sub-portion 114 and the second sub-portion 116 are vertically stacked, and the first external wall 115 extends differently from the second external wall 117 along the vertical direction.

The first external wall 115 comprises in this example a vertical extension and straight extension, whereas the second external wall 117 comprises an inclined extension that is not a straight extension (an irregular extension), wherein the inclination of the first external wall 115 is different from the inclination of the second external wall 117.

Hereby, the second sub-portion 116 does not have a symmetrical shape. As can be seen in Figure 1A, only the second external wall 117 on the left hand side is inclined, compared to the right hand side, which has a stepped structure, thereby comprising a horizontal and vertical sidewall.

The first sub-portion 114 is delimited in this example by one electrically insulating structure 123 and a part (partially) of an electrically insulating structures 112 (in another example, compare Figure 2A, four electrically insulating layer structures 102), and the second sub-portion 116 is delimited by exclusively one electrically insulating layer structure 112, in this example here a core for stability. In another example, the inclination can be also through several electrically insulating/conductive layers.

The second external wall 117 of the second sub-portion 116 and the lateral wall of the second cavity portion 120 define an exposed profile 118 within the cavity 105, here with an electrically conductive material/coating at the sidewall of a second electrically insulating layer structure 122 (compare also the detailed view of Figure 2A).

The cavity 105 is fully metallized by a metalized layer 150 in this example. Hereby, a metalized portion of the metalized layer 150 comprises multiple stacked metalized layers, and the metalized portion corresponds to the lateral wall of the first cavity portion 110 and the lateral wall of the second cavity portion 120. Further, a first metalized portion of the metalized layer 150 that corresponds to the lateral wall of the first cavity portion 110 can be equal, thinner or thicker than a second metalized portion of the metalized layer 150 that corresponds to the lateral wall of the second cavity portion 120.

The cavity 105 is configured as a wave guide, e.g. for at least one of the following applications: HF, radar, mm-wave, 60 GHz or higher applications, in particular a RF applications for mm-wave or higher (e.g. radar, 5G, 6G, etc.). An electric component 160 is arranged/mounted at the bottom of the stack 101 on the cavity 105, e.g. for transmitting an RF signal into the wave guide (here into the first cavity portion 110). The cavity 105 is open on one extremity (bottom) and closed on the opposed other extremity (top). The opposed other extremity can be in direct and/or indirect contact with an antenna structure.

In the example of Figure 1A, the cavity 105 (in particular the wave guide) comprise a constant cross-sectional area A (at least at dedicated portions of the wave guide). In an example, this is the reason, why the inclination is implemented (to keep the diameter constant) for less signal losses.

The exposed electrically conductive layer structures 104 on the opposed main surfaces of the stack 101 may be structured. Optionally, a solder resist and/or a surface finish may be provided at the exposed main surfaces of the stack 101. The respective electrically conductive layer structures 104 can be vertically connected by electrically conductive vertical connections, for example metal filled vias (see Figure 2A).

**Figure 1B** shows a further component carrier 100, according to an exemplary embodiment of the invention. The component carrier 100 is comparable to the one described for Figure 1A; yet, the cavity 105 (wave guide) does not have a constant cross-section A. Instead, the second cavity portion 120 in Figure 1B is much larger (in the width/area) than the first cavity portion 110.

**Figure 2A** shows a microscopic image of a cross-section through a component carrier 100 and **Figure 2B** shows a schematic illustration of the same view of said component carrier 100, according to an exemplary embodiment of the invention. In these Figures, the component carrier 100 is upside down with respect to Figure 1A. The first cavity portion 110 is formed from the upper main surface of the stack 101, whereas the second cavity portion 120 is formed from the lower main surface of the stack 101 (additional layers have been added below the second cavity portion 120).

The first sub-portion 114 of the first cavity portion 110 vertically extends along the thickness direction of four electrically insulating layer structures 102 and four electrically conductive layer structures 104. Hereby, the first sub-portion 114 vertically extends (only) partially along the lowermost (the first) of said electrically insulating layer structures 112. It can be seen that the straight vertical extension changes to an inclination that defines the second sub-portion 116 of the first cavity portion 110.

The second external wall 117 of the second sub-portion 116 of the first cavity portion 110 follows an extension in the horizontal direction (by an inclination) and delimits thereby an intermediate cavity surface 119 (essentially planar) on the first electrically insulating layer structure 112. The intermediate cavity surface 119 can comprise a roughness (can be seen in the Figure 2A) (specifically a roughness higher than the roughness of the lateral wall of the first cavity portion 110, in particular of the first external wall 115 of the first sub-portion 114). Such a roughness may define patterned circular sketches, e.g. reflecting a routing manufacture process (compare Figure 3).

In an example, at least a portion of the first external wall 115 and/or at least a portion of the intermediate cavity surface 119 may be free from electrically conductive material, in particular metal. Additionally or alternatively, at least a portion of the first external wall 115 and/or at least a portion of the intermediate cavity surface 119 may comprise electrically conductive material, in particular metal (see Figure 1A).

The second external wall 117 of the second sub-portion 116 and the lateral wall of the second cavity portion 120 define an exposed profile 118 within the cavity 105, here with an electrically conductive material/coating at the sidewall of a second electrically insulating layer structure 122. In an example, at least a portion of the second external wall 117 may be free from electrically conductive material, in particular metal.

The first electrically insulating layer structure 112 comprises a reinforcing structure 140 embedded therein, here reinforcing fibers (e.g. a prepreg). The second external wall 117 of the second sub-portion 116 delimits the intermediate cavity surface 119 on the first electrically insulating layer structure 112 (in thickness direction) and the reinforcing structure 140 is partially exposed at the intermediate cavity surface 119 (an exposed fiber can be seen, compare also Figure 4A). Different portions of the second sub-portion 116 can expose a different amount and/or a different portion of the reinforcing structure 140. The reinforcing structure 140 is exposed lengthwise with respect to the second sub-portion 116 extension towards the second cavity portion 120.

In an embodiment (not shown), the inclination is metallized (has a metal coating), otherwise the signal may escape in this area leading to signal losses. In this example, the reinforcing material may not be exposed.

**Figure 3** shows a top view on a portion of a component carrier 100, according to an exemplary embodiment of the invention. In particular, Figure 3 shows a top view on the intermediate cavity surface 119, the exposed profile 118 and the electrically conductive layer structure 104 formed at the bottom of the second cavity portion 120 as shown in Figures 2A and 2B. In this top view, it can be seen that the lateral wall 115 of the first cavity portion 110 defines a rounded profile in the planar view (a polyhedral profile with rounded edges). The exposed profile 118 defines also rounded profiles, when seen from the planar view. Specifically, the exposed profile 118 comprises rounded traces that reflect a routing manufacture process (traces from the routing bit).

**Figure 4A** shows a microscopic image of a cross-section through a component carrier 100 and **Figure 4B** shows a schematic illustration of said component carrier 100, according to an exemplary embodiment of the invention. Like in Figure 2A, the first sub-portion 114 of the first cavity portion 110 extends vertically along the thickness direction of a plurality of electrically insulating layer structures 102. Along the thickness of the first electrically insulating layer structure 112, the vertical extension changes to a (horizontal) inclination that defines the second sub-portion 116 of the first portion 110. The inclination defines an intermediate cavity surface 119, which shows in this Figure exposed fibers (reinforcing structures) 140. These fibers 140 have been exposed during a cavity formation process (in particular routing). The second sub-portion 116 is further connected to the second cavity portion 120 that comprises vertically straight lateral walls, thereby defining the exposed profile 118.

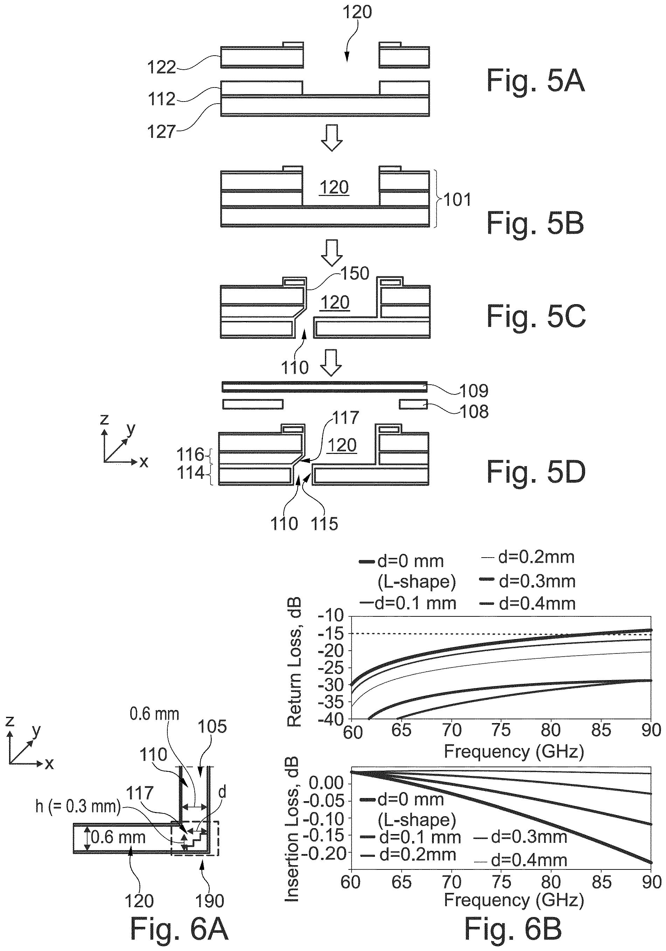

**Figures 5A, 5B, 5C, and 5D** show a process of manufacturing a component carrier 100, according to an exemplary embodiment of the invention.

Figure 5A and Figure 5B: a preform of a stack 101 is provided by stacking (laminating) a fourth electrically insulating layer structure 123, a first electrically insulating layer structure 112, and a second electrically insulating layer structure 122 (with alternating electrically conductive layer structures 104). A second cavity portion 120 is formed by drilling from above (z+) into the stack 101 through the first electrically insulating layer structure 112 and the second electrically insulating layer structure 122 (and optionally electrically conductive layer structures 104).

In an embodiment, a first part of the second cavity portion 120 can be formed in the first electrically insulating layer structure 112, and then a core layer, being the second electrically insulating layer structure 122, with an already formed second part of the second cavity portion 120, is arranged/laminated on top.

In a specific example, a plug-in paste is applied on a milled core 122 and a (no-flow) prepreg 112 is applied on a further core 123. Then, relamination is done to merge the two (symmetrical) cores 122, 123.

Figure 5C: a first cavity portion 110 is formed by drilling from below (z-) into the stack 101 through the fourth electrically insulating layer structure 123 and the first electrically insulating layer structure 112. Cavity formation is done such that the first cavity portion 110 and the second cavity portion 120 are connected along their vertical extension. Drilling the first cavity portion 110 comprises forming an inclined or stepped region in the first electrically insulating layer structure 112, e.g. by using a routing process. Further, lateral walls of the cavity 105 are metalized 150, in particular using plating.

In a specific example, controlled depth-routing is used to obtain the opening 110. Then, electroless copper and plating is used for obtaining shielded sidewalls.

Figure 5D: after formation of the cavity 105, further layer structures can be added (build-up process), e.g. a further electrically insulating layer structure 108 and a further core layer 109. In a specific example, an etched core 109 is used to seal the cavity by applying a sinter paste and a pre-cut prepreg 108 in between.

The second cavity portion 120 is formed in a first portion of the stack 101, and the first cavity portion 110 is formed afterwards by drilling in a second portion of the stack 101. The first cavity portion 110 is formed from a first direction (+z), the second cavity portion (120) is formed from a second direction (-z), and the first direction (+z) is opposed to the second direction (-z).

**Figure 6A** shows an illustration of a waveguide 105 in a component carrier 100 in a cross sectional view, while **Figure 6B** shows simulation results for said wave guide 105, according to an exemplary embodiment of the invention.

Figure 6A: at the interface of a vertical portion and a horizontal portion of the wave guide 105 (the bending portion 190), there is formed a multi-step portion 117. The wave guide 105 has an extension in height and width being 0.6 mm. Alternatively, the wave guide 105 may have an extension in height and/or width smaller or larger than 0.6 mm. The bending portion 190 and/or the second external wall 117 has a delimitation d (in lateral extension) and/or height h. In this example the height h of the bending portion 190 and/or the second external wall 117 has an extension of 0.3 mm. Preferably, the extension of the wave guide 105 may stay constant in the bending portion 190. This may be achieved by the limitation of the extension of the wave guide 105 by the delimitation d and/or height h of the second external wall 117.

Figure 6B shows how the signal loss is increasing if the diameter of the wave guide 105 does not stay constant, specifically: the signal losses when an L-shape has been obtained (without back-drilling). The 0,4 mm line shows the losses if the diameter stays constant. At 77 GHz, the losses can thereby be reduced by roughly -0.10 dB (insertion loss) compared with an example where the diameter and/or the cross-sectional area A of the wave guide 105 does not stay constant.

In an example, if the delimitation d is 0 mm, the diameter of the wave guide 105 changes in the bending portion 190, which are creating said insertion losses. By an increase of the delimitation d, the diameter of the wave guide 105 decreases in the bending portion 190 and thus approaches the diameter of the wave guide 105 outside the bending portion 190. Preferably, there is an optimum value of the delimitation d.

Reducing the mm corresponding to different losses obtained when the diameter changes (dB are increasing from 0,4 mm to 0 mm which corresponds to the structure without back-drilling).

The term E-bend refers to the electrical field, whereas H-bend refers to the magnetic field. A RF signal is an electromagnetic field comprising an electric- and a magnetic field. The height in a waveguide is related to the losses in E-bend (denoted as A in Figure 1A), whereas the width in a waveguide is related to the H-bend. Within the waveguide as shown, the width stays constant also in the L-shaped version. However, the height in the L-shaped version changes - it increases (corresponding to the mm changes in Figure 6B). Accordingly, E-bend is affected, leading to losses during the E-bend transition.

The described invention may aim to keep the height constant (as the width is constant throughout the channel already) resulting in less signal losses (losses in E-bend). For example, the losses can be reduced by a factor 10 in this area (shown in Figure 6B).

**Figure 7a, Figure 7B, Figure 7C, and Figure 7D** show manufacturing a further component carrier 100, according to an exemplary embodiment of the invention.

Figure 7A: there is provided a stack 101 comprising a plurality of electrically insulating layer structures and electrically conductive layer structures.

Figure 7B: cavity formation (e.g. drilling) is started in the uppermost (second) electrically insulating layer structure 122 to provide a second cavity portion 120.

Figure 7C: the second cavity portion 120 has been formed in the second electrically insulating layer structure 122 as a horizontally elongated structure. A first electrically insulating layer structure 112 is formed/laminated on top of the second electrically insulating layer structure 122. A first cavity portion 110 is formed by drilling from above through the first electrically insulating layer structure 112 to connect the first cavity portion 110 with the second cavity portion 120. When drilling down, a second sub-portion 116 (inclined portion) is formed at the interface between the first cavity portion 110 and the second cavity portion 120.

Figure 7D: a third electrically insulating layer structure 132 is formed/laminated on top of the first electrically insulating layer structure 112. Further, a third cavity portion 130 has been formed in the third electrically insulating layer structure 132 as a horizontally elongated structure. A third sub-portion 133 (inclined portion) is formed at the interface between the first cavity portion 110 and the third cavity portion 130.

The cavity 105 comprises a third cavity portion 130 connected to the first cavity portion 110 and arranged opposed to the second cavity portion 120. The first cavity portion 110, the second cavity portion 120, and the third cavity portion 130 are connected one to each other through their vertical extension (z) in the stack 101.

The cavity 105 has a U-shaped cross section, wherein the two extremities are defined by the second cavity portion 120 and the third cavity portion 130, and wherein said extremities are connected by the first cavity portion 110. The first cavity portion 110 partially vertically extends in the thickness of two electrically insulating layer structures 122, 132 composing the stack 101, and each one of said two electrically insulating layer structures 122, 132 is connected to either the second cavity portion 120 or the third cavity portion 130. The first cavity portion 110 comprises a third sub-portion 133 arranged opposite to the second sub-portion 116 and stacked with the first sub-portion 114. The third sub-portion 133 comprises an external wall extending differently than the first external wall 115 of the first sub-portion 114.

Additionally, a component 160 (e.g. RF-IC) is embedded in the stack 101 and coupled to the second cavity portion. In this manner, the component (e.g. an RF component) 160 may couple an RF signal into the common cavity 105 that functions as a wave guide. It is schematically shown in the Figure that electromagnetic waves are transmitted from the stack 101, in particular by transport of the signal from the component 160, through the wave guide 105 to an external surface of the stack 101 (which can comprise an antenna).

In an exemplary embodiment, using other words, the process of Figures 7A to 7D can be described as follows: it is started with a V-shape drill on a substrate. This can be done by using for example controlled depth drilling with special bits such as V-shape drill bits, tilted drilling, or triangle drill bits, or by laser drilling with beams which allow the creation of V-shape holes. Then, a standard wave guide manufacturing procedure and sidewall metallization can be carried on from or until the middle of the first created V-shape hole, which allows the implementation of embedded wave guides with chamfered edges either on Z-axis (vertical side of the stack) or X-Y-axis (horizontal side of the stack).

A component such as an RFIC can be embedded or surface mounted, which can feed the wave guide directly or through component carrier transitions such as microstrip to embedded wave guide, stripline to wave guide, slot coupling, SIW to waveguide, etc. This proposed method can be repeated to create a double-chamfered edged air-filled embedded wave guide. The proposed chamfered edged air-filled embedded wave guide can be used as a feeding structure to the antenna, as wave guide and slotted wave guide antenna, or as a wave guide.

**Figure 8B and Figure 8C** show respectively a component carrier 100, according to exemplary embodiments of the invention.

Figure 8B: a wave guide 105 is formed in a component carrier 100 stack, for example as described for Figures 1A and 1B, by a first cavity portion 110 and a second cavity portion 120, both vertically connected. The first cavity portion 110 comprises a second sub-portion 116 with a slanted (inclined) external wall 117 at the E-bend transition (signal bending portion/region). In an example, a signal can be inserted at the top of the component carrier 100 in the first cavity portion 110, travel through the first cavity portion 110, and be bent at the bending region 117 in the second cavity portion 120, to be emitted through a slot antenna 191. In comparison to the prior art example of Figure 8A, the insertion loss may be reduced, for example to 0.01 dB by this architecture.

Figure 8C: a wave guide 105 is formed in a component carrier 100 stack, for example as described for Figures 1A and 1B, by a first cavity portion 110 and a second cavity portion 120, both vertically connected. The first cavity portion 110 comprises a second sub-portion 116 with a multi-stepped external wall 117 (exposed portion) at the E-bend transition (signal bending region). In an example, a signal can be inserted at the top of the component carrier 100 in the first cavity portion 110, travel through the first cavity portion 110, and be bent at the bending region 117 in the second cavity portion 120, to be emitted through a slot antenna 191. In comparison to the prior art example of Figure 8A, the insertion loss may be reduced, for example to 0.01 dB by this architecture.

### Reference signs

- 100: Component carrier
- 101: Stack
- 102: Electrically insulating layer structure
- 104: Electrically conductive layer structure
- 105: Cavity, wave-guide
- 108: Further electrically insulating layer structure
- 109: Further core layer
- 110: First cavity portion
- 112: First electrically insulating layer structure
- 114: First sub-portion
- 115: First external/lateral wall
- 116: Second sub-portion
- 117: Second external wall
- 118: Exposed profile
- 119: Intermediate cavity surface
- 120: Second cavity portion
- 122: Second electrically insulating layer structure
- 123: Fourth electrically insulating layer structure
- 130: Third cavity portion
- 132: Third electrically insulating layer structure
- 133: Third sub-portion
- 140: Reinforcing structures
- 150: Metallized wall
- 160: Electric component
- 190: Bending portion
- 191: Slot antenna

## Claims

1. A component carrier (100) having a stack (101), wherein the stack (101) comprises:
at least one electrically conductive layer structure (104) and at least one electrically insulating layer structure (102); and
a cavity (105) provided in the stack (101), wherein the cavity (105) comprises:
a first cavity portion (110) provided on a first vertical level (h1) of the stack (101),
wherein the first cavity portion (110) partially vertically extends along the thickness of a first electrically insulating layer structure (112) of the at least one electrically insulating layer structure (102), and
a second cavity portion (120) provided on a second vertical level (h2) of the stack (101),
wherein the first cavity portion (110) and the second cavity portion (120) are connected to each other through their vertical thickness extension (z) in the stack (101).

2. The component carrier (100) according to claim 1, wherein the first cavity portion (110) comprises:
a first sub-portion (114) with a first external wall (115), in particular a lateral wall, and
a second sub-portion (116) with a second external wall (117),
wherein the first sub-portion (114) and the second sub-portion (116) are, in particular vertically, stacked, and
wherein the first external wall (115) extends differently from the second external wall (117), in particular along the vertical direction (z).

3. The component carrier (100) according to claim 2,
wherein the first external wall (115) comprises a vertical extension and/or straight extension, and
wherein the second external wall (117) comprises an inclined extension and/or a not straight extension.

4. The component carrier (100) according to claim 2 or 3,
wherein the first sub-portion (114) is delimited by two or more electrically insulating structures (102), and/or
wherein the second sub-portion (116) is delimited by one, in particular exclusively one, electrically insulating layer structure (102).

5. The component carrier (100) according to one of the preceding claims,
wherein the first cavity portion (110) and the second cavity portion (120), in particular the second external wall (117) of the second sub-portion (116) and the lateral wall of the second cavity portion (120), define an exposed profile (118) within the cavity (105);
in particular
wherein the exposed profile (118) comprises a multi-step portion; and/or
wherein the exposed profile (118) defines at least one rounded profile, when seen from a planar view (z); and/or
wherein the exposed profile (118) comprises rounded traces that reflect a routing manufacture process.

6. The component carrier (100) according to one of the preceding claims,
wherein the first cavity portion (110), in particular the second external wall (117) of the second sub-portion (116), delimits an intermediate cavity surface (119), in particular planar, on the first electrically insulating layer structure (112), and
wherein the intermediate cavity surface (119) comprises a roughness that defines patterned circular sketches, in particular reflecting a routing manufacture process.

7. The component carrier (100) according to one of the preceding claims,
wherein the first electrically insulating layer structure (112) comprises a reinforcing structure (140) embedded therein,
wherein the first cavity portion (110), in particular the second external wall (117) of the second sub-portion (116), delimits the intermediate cavity surface (119) on the first electrically insulating layer structure (112), and
wherein the reinforcing structure (140), in particular at least partially covered by a metal layer, is partially exposed at the intermediate cavity surface (119).

8. The component carrier (100) according to claim 7,
wherein different portions of the second sub-portion (116) expose a different amount and/or a different portion of the reinforcing structure (140), in particular at least partially covered by the metal layer.

9. The component carrier (100) according to one of the claims 6 to 8,
wherein the intermediate cavity surface (119) has a roughness higher than the roughness of the lateral wall of the first cavity portion (110), in particular of the first external wall (115) of the first sub-portion (114).

10. The component carrier (100) according to one of the preceding claims,
wherein the lateral wall of the first cavity portion (110) defines a rounded profile in a planar view, in particular a polyhedral profile with rounded edges.

11. The component carrier (100) according to one of the preceding claims,
wherein the cavity (105) is at least partially, in particular fully, metallized, in particular by a metalized layer (150).

12. The component carrier (100) according to one of the preceding claims ,
wherein the first cavity portion (110) and the second cavity portion (120) partially overlap along the stack thickness direction (z).

13. The component carrier (100) according to one of the preceding claims,
wherein the cavity (105) comprises a third cavity portion (130) connected to the first cavity portion (110) and arranged opposed to the second cavity portion (120), and
wherein the first cavity portion (110), the second cavity portion (120), and the third cavity portion (130) are connected one to each other through their, in particular vertical, extension (z) in the stack (101),
in particular
wherein the cavity (105) has a U-shaped cross section,
wherein the two extremities are defined by the second cavity portion (120) and the third cavity portion (130), and
wherein said extremities are connected by the first cavity portion (110).

14. The component carrier (100) according to claim 13,
wherein the first cavity portion (110) comprises a third sub-portion (133) arranged opposite to the second sub-portion (116) and stacked with the first sub-portion (114), and
wherein the third sub-portion (133) comprises an external wall extending differently than the first external wall (115) of the first sub-portion (114).

15. A method of manufacturing a component carrier (100), the method comprising:
providing a stack (101) having at least one electrically conductive layer structure (104) and at least one electrically insulating layer structure (102);
providing a cavity (105) in the stack (101), so that the cavity (105) comprises:
a first cavity portion (110) provided on a first vertical level (h1) of the stack (101), wherein the first cavity portion (110) partially vertically extends along the thickness of a first electrically insulating layer structure (112) of the at least one electrically insulating layer structure (112), and
a second cavity portion (120) provided on a second vertical level (h2) of the stack (101),
wherein the first cavity portion (110) and the second cavity portion (120) are connected one to each other through their vertical thickness extension (z) in the stack (101).
